# EUROPEAN PATENT APPLICATION

(11) **EP 1 921 677 A1**
(43) Date of publication of application: **14.05.2008**
(21) Application number: 07118834.6
(22) Date of filing: 19.10.2007
(51) Int. Cl.: H01L 27/144, H01L 31/0216

(54) **Light shield for a back illuminated light-detecting element and corresponding device**

(30) Priority: 08.11.2006 JP 2006303400
(71) Applicant: NEC CORPORATION, Minato-ku, Tokyo 108-8001 (JP)
(72) Inventor: KAWAI, Motoyoshi, Tokyo Tokyo 108-8001 (JP)
(74) Representative: Vossius & Partner

(57) **Abstract**

To prevent light under an oblique angle from reaching the photo-sensitive region a light shield (7) is placed on the back side of a back illuminated light detecting element (1). The light conversion region (4) is formed on the front side of the light detecting element. Light coming from a wavelength division multiplexing receiver is first filtered by a dielectric multilayer film (21) before reaching the back-side of the light detecting element (1). The opening (8) in the light shield (7) corresponds to the photo-sensitive region and its size is adjusted so that mainly parallel light reaches the photo-sensitive region, based on the distance between the light reaches the photo-sensitive region.

## Description

This application is based upon and claims the benefit of priority from Japanese patent application No. 2006-303400, filed on November 8, 2006, the disclosure of which is incorporated herein in its entirety by reference.

The present invention relates to a light-receiving element and a light-receiving device including the light-receiving element loaded thereon, which are used for optical communications.

The optical communications using optical fibers are not only used in basic systems but also used widely in subscriber systems. In accordance with this, it has been tried to reduce the size and cost of light-transmitting devices and light-receiving devices used in optical communication systems.

Further, as a system for achieving transmission of a large volume of light, a WDM (Wavelength Division Multiplex) transmission system has been put into practical use broadly. It is a system where a plurality of data signals is put into optical signals of different wavelengths from each other, and those optical signals in plurality of wavelengths are multiplexed and transmitted on a single optical fiber.

With the optical communication of the WDM transmission system, it is common to provide the light-receiving device with a wavelength selecting function. Japanese Unexamined Patent Publication 2003-142699 (Patent Document 1) discloses a light-receiving device that only receives light of a specific wavelength. The light-receiving device of Patent Document 1 includes a light-receiving element loaded on a sub-mount that has an opening, and a wavelength selecting film formed with a dielectric multilayer film is fixed to the opening.

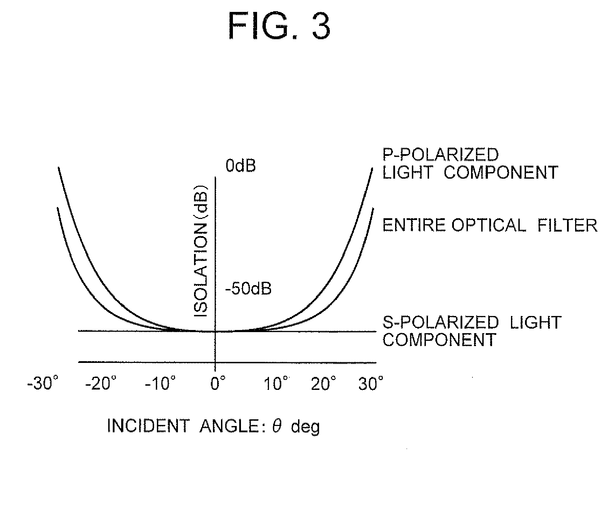

However, an optical filter formed with a dielectric multilayer film has such a characteristic that isolation of a P-polarized light component becomes deteriorated compared to that of an S-polarized light component when the incident angle of the light becomes larger. Thus, the isolation property at the optical filter is deteriorated, and there is a risk of having signal light in a wavelength band (which is other than the wavelength band that is to be transmitted originally) mixed in the light that makes incident obliquely and transmits through the optical filter of the dielectric multilayer film. FIG. 3 shows the filter characteristic of such dielectric multilayer film.

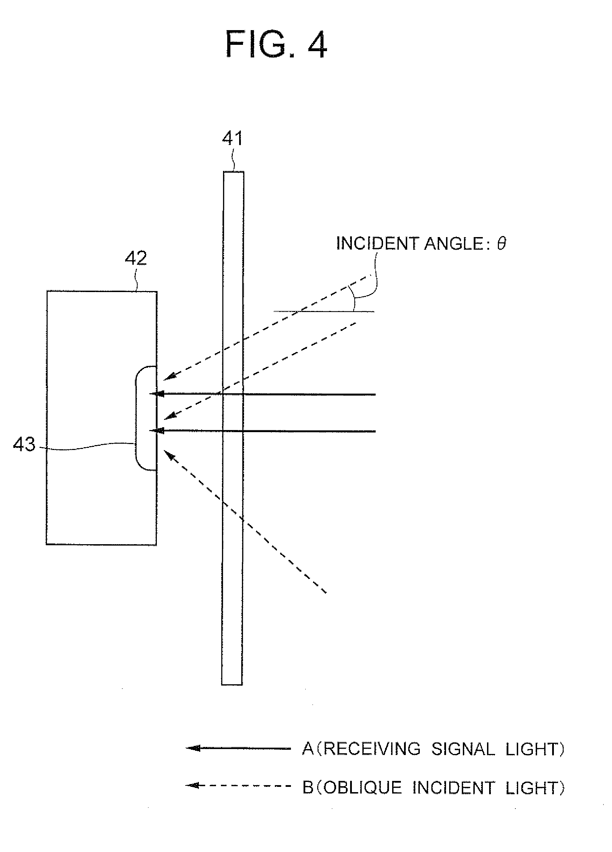

In the light-receiving device of Patent Document 1, an optical filter 41 formed with a dielectric multilayer film having the above-described film characteristic is disposed in an incident-face side of a light-receiving element 42. However, the light making incident obliquely on the optical filter 41 is optically coupled with a light-receiving part 43 of the light-receiving element 42 easily (see FIG. 4), so that there is received the light to which the signal light of unnecessary wavelength band is mixed.

An exemplary object of the present invention therefore is to efficiently eliminate the light that makes incident on the optical filter obliquely, and to optically couple only the parallel light or the light close that state with the light-receiving part in the optical system where the light-receiving element is disposed on the emission-face side of the optical filter that is formed with a dielectric multilayer film.

In order to achieve the foregoing exemplary object, the light-receiving element according to an exemplary aspect of the present invention is a back-face incident type light-receiving element including a light-receiving part region formed on an opposite-face side of a light incident face, wherein a light-shielding film layer, which has an opening that corresponds to a position of the light-receiving part region, is formed integrally on the light incident face.

With such light-receiving element, it is possible to achieve fine isolation by eliminating the light that makes incident obliquely on the dielectric multilayer film disposed on the light-incident side of the light-receiving element, and optically coupling the parallel light or the light close to that state with the light-receiving part of the light-receiving element. Further, since the light-shielding pattern is provided on the incident face of the light-receiving element itself, it is unnecessary to use a sub-mount that is used in a conventional case. Therefore, it is possible to shield the oblique incident light while maintaining the small size.

Further, the light-receiving device according to another aspect of the present invention is a light-receiving device used for optical communications, to which the above-described light-receiving element (the light-receiving element of the exemplary aspect of the present invention) is mounted to the main body of the light-receiving element. Such light-receiving device includes the light-receiving element that eliminates the oblique incident light and receives only the parallel light or the light close to that state, so that the light making incident obliquely on the optical filter is not received at the light-receiving element when the optical filter formed with the dielectric multilayer film is provided. Further, it is unnecessary to provide the sub-mount that is used in the conventional case, so that the size and cost can be reduced.

As an exemplary advantage according to the invention, in the case of the optical system where the light-receiving element is disposed on the emission-face side of the dielectric multilayer film, the present invention prevents the optical coupling of the light that makes incident obliquely on the dielectric multilayer film and the light-receiving part region, and optically couples only the parallel light or the light close to that state with the light-receiving part region. Therefore, fine isolation can be achieved. Further, since the light-shielding pattern is provided on the incident face of the light-receiving element itself, it is unnecessary to provide the sub-mount that is used in the conventional case. Therefore, the size can be reduced.

An exemplary embodiment of the present invention will be described hereinafter by referring to the accompanying drawings.
FIG. 1 is a sectional view for showing a structure of a light-receiving element according to an exemplary embodiment of the present invention;
FIG. 2 is an illustration for describing a light-receiving device to which the light-receiving element according to the exemplary embodiment shown in FIG. 1 is loaded;
FIG. 3 is an illustration for showing the isolation characteristic of a dielectric multilayer film; and
FIG. 4 is an illustration for describing an optical system that uses a light-receiving element of a related art.

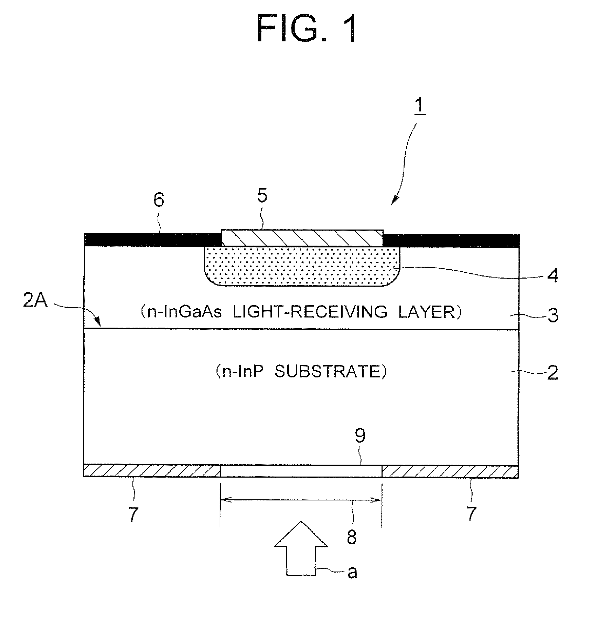

FIG. 1 is a sectional view for showing the structure of a light-receiving element 1 according to the exemplary embodiment.

As shown in FIG. 1, the light-receiving element 1 is a back-face incident type, in which an n-type light-receiving layer 3 is epitaxially grown on one face 2A (upper face in FIG. 1) of an n-type substrate 2. In this exemplary embodiment, an n-InGaAs light-receiving layer 3 as the n-type light-receiving layer 3 is epitaxially grown on an n-InP substrate 2 as the n-type substrate 2.

A p-region 4 as a light-receiving part region is formed in the center part of the n-InGaAs light-receiving layer 3 by diffusing Zn. The boundary line of the p-region 4 is a PN-junction. A p-electrode 5 covers almost the entire surface of the p-region 4, and a surface protection film 6 is laminated on the part other than the p-electrode 5.

Further, an n-electrode 7 with an opening 8 in its center part is deposited on a light-incident side face (lower face in FIG. 1) of the n-InP substrate 2. This n-electrode 7 also functions as a light-shielding film layer for shielding the oblique incident light. Furthermore, an antireflection film 9 such as SiO₂ is provided at the opening 8. By providing the antireflection film 9, it is possible to capture still larger amount of light through improving the transmittance by preventing the reflection of the light at the surface of the incident face.

When a reverse bias voltage (the n-electrode 7 is positive, and the p-electrode 5 is negative) is applied between the p-electrode 5 and the n-electrode 7, a depletion layer in the vicinity of the PN-junction becomes large. Thus, an electric field is generated from the n-InP substrate 2 towards the p-electrode 5. When signal light a makes incident from the antireflection film 9, it reaches the depletion layer after transmitting through the n-InP substrate 2 and the n-InGaAs light-receiving layer 3, and generates electron-hole pairs. The electrons generated in the depletion layer move to the n-region, and the positive holes move to the p-region, so that there is a flow of photoelectric current.

The opening 8, which is in a size that corresponds to the plane shape of the p-region 4 of the light-receiving part region, is formed in the center part of the n-electrode 7. The size of the opening 8 is so calculated and set that only the parallel light or the light close to that state is optically coupled with the p-region 4, based on the distance from the light-incident face to the p-region 4 of the light-receiving part region-Specifically, the size of the opening 8 is so calculated that the only the light with the incident angles of 90±10 degrees, which correspond to the flat part in a graph of FIG. 3 that shows the isolation characteristic of the optical filter, can reach the p-region 4. Practically, it is the size almost equal (light-receiving diameter of 50 µm - 80 µm) to a reflection of the plane shape of the p-region 4, or it is smaller than the plane shape of the p-region 4.

In this exemplary embodiment, the n-electrode 7 is in a structure that also functions as a light-shielding film layer for shielding the oblique incident light. However, it is not limited to that structure. It is also possible to form the n-electrode 7 in a part of the light-incident side face of the n-InP substrate 2, form a light-shielding film layer on the part other than the n-electrode 7, and provided an opening in the light-shielding film layer. The opening in this case is also set to have the same size as the opening 8 of the n-electrode 7 described above.

As described above, the light-receiving element 1 of the exemplary embodiment has the light-shielding film layer formed on the light-receiving element 1 itself, so that it is possible to shield the oblique incident light without changing the size (to keep the small size). Therefore, the light-receiving element 1 receives only the parallel light or the light close to that state at all times.

Next, described is a case where a dielectric multilayer film 21 is disposed on the incident-face side of the light-receiving element 1 of the exemplary embodiment.

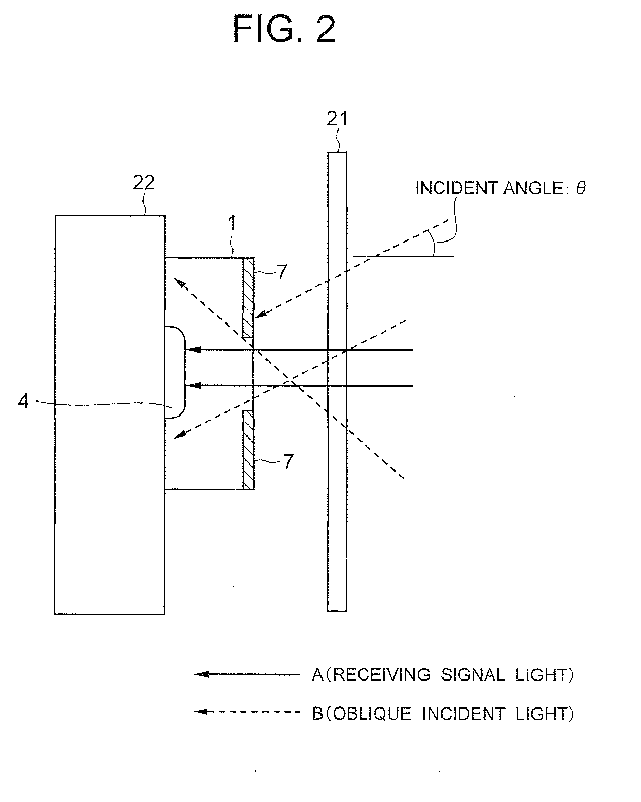

FIG. 2 is an illustration for showing a light-receiving device 20 where the dielectric multilayer film (21) is disposed on the incident-face side of the light-receiving element 1 of the exemplary embodiment. As shown in FIG. 2, the light-receiving device 20 includes an optical filter 21 that is formed with the dielectric multilayer film, the light-receiving element 1, and a carrier 22 for carrying the light-receiving element 1. In the light-receiving device 20, light B that obliquely makes incident on the dielectric multilayer film 21 is shielded by the light-shielding film layer (n-electrode) 7 formed on the light-receiving element 1 itself. Even if the light transmits therethrough, it cannot be optically coupled with the p-region 4. Meanwhile, parallel light that makes incident almost perpendicularly to the dielectric multilayer film 21 or light A that is close to that state can reach the p-region 4, and such light can be optically coupled therewith.

As described above, in the light-receiving element 1 of the exemplary embodiment has the light-shielding film layer (n-electrode) 7 formed integrally on the light-incident face thereof, and only the parallel light or the light close to that state is optically coupled with the p-region 4 of the light-receiving part region due to the setting of the size of the opening 8 that is provided to the light-shielding film layer (n-electrode) 7. Therefore, when the light-receiving element 1 of the exemplary embodiment is used for the optical system such as the one shown in FIG. 2 where the light-receiving element is disposed on the emission-face side of the dielectric multilayer film, it is possible to prevent the optical coupling of the light that makes incident obliquely on the dielectric multilayer film and the p-region 4, and optically couple only the parallel light or the light close to that state so as to achieve fine isolation. Further, since the light-shielding pattern is provided to the incident face of the light-receiving element 1 itself, it is unnecessary to attach a sub-mount. Thus, it is possible to simplify the structure of the optical module and to reduce the number of components, which makes it possible to reduce the size of the module and to cut the cost.

Furthermore, in the light-receiving element 1 of the exemplary embodiment, the light-shielding film layer with an opening indicating the position of the light-receiving part region (p-region 4) is formed on the incident face at the manufacturing stage. Therefore, the position of the light-receiving part region can be easily detected by checking the position of the opening 8. When performing passive alignment mount at the time of manufacturing the optical module, it is possible with the use of the light-receiving element 1 of the exemplary embodiment to achieve the accurate mount, through executing it by checking the position of the opening 8.

Next, another exemplary embodiment of the present invention will be described.

In the light-receiving element described above, the opening of the above-described light-shielding film layer may be in a size that is determined based on a distance from the light incident face to the light-receiving part region. With this, it is possible to configure a structure where only the parallel light or the light close to that state can be optically coupled with the light-receiving part region.

Further, in the light-receiving element described above, the opening of the above-described light-shielding film layer may be in a size that is a reflection of a plane shape of the light-receiving part region. With this, it becomes possible to configure a structure where only the parallel light or the light close to that state can be optically coupled with the light-receiving part region. In addition, it becomes possible to detect the position of the light-receiving part region easily.

Furthermore, in the light-receiving element described above, the opening of the above-described light-shielding film layer may be in a size that is smaller than a plane shape of the light-receiving part region. With this, it is possible to configure a structure where only the light that is still closer to the parallel light can be optically coupled with the light-receiving part region.

Moreover, in the light-receiving element described above, the above-described light-shielding film layer may be an electrode. With this, the light-receiving element can be manufactured only with the materials used conventionally, without using an additional lamination material. Therefore, the size and cost of the element can be reduced.

Further, in the light-receiving element described above, the above-described light-shielding film layer may be deposited on the light incident face. In this structure, the light-shielding pattern is formed on the element itself. Therefore, the oblique incident light can be shielded at all times while maintaining the small size.

Furthermore, in the light-receiving element described above, an antireflection film may be formed on the opening of the above-described light-shielding film layer. This makes it possible to prevent reflections at the surface of the incident face, so that the transmittance can be improved.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

## Claims

1. A back-face incident type light-receiving element comprising a light-receiving part region formed on an opposite-face side of a light incident face, wherein
a light-shielding film layer is provided on the light incident face, and an opening is provided to the light-shielding film layer at a position that corresponds to the light-receiving part region.

2. The light-receiving element as claimed in claim 1, wherein the opening is in a size that is determined based on a distance from the light incident face to the light-receiving part region.

3. The light-receiving element as claimed in claim 1, wherein the opening is in a size that is a reflection of a plane shape of the light-receiving part region.

4. The light-receiving element as claimed in claim 1, wherein the opening is in a size that is smaller than a plane shape of the light-receiving part region.

5. The light-receiving element as claimed in claim 1, 2, 3 or 4 wherein the light-receiving part region is in a PN-junction structure.

6. The light-receiving element as claimed in claim 5, wherein a photoelectric current as an input signal flows in the light-receiving part region because of a depletion layer generated in a vicinity of the PN-junction when a reverse bias voltage is applied.

7. The light-receiving element as claimed any one of claims 1 to 6, wherein the light-shielding film layer is an electrode.

8. The light-receiving element as claimed in any one of claims 1 to 7, wherein the light-shielding film layer is deposited on the light incident face.

9. The light-receiving element as claimed in any one of claims 1 to 8, wherein an antireflection film is formed on the opening of the light-shielding film layer.

10. A light-receiving device comprising a light-receiving element mounted on the light-receiving device itself for an optical communication, wherein:
the light-receiving element is a back-face incident type light-receiving element that has a light-receiving part region formed on an opposite-face side of a light incident face; and
a light-shielding film layer is provided on the light incident face, and an opening is provided to the light-shielding film layer at a position that corresponds to the light-receiving part region.
